# EUROPEAN PATENT APPLICATION

(11) **EP 4 750 308 A1**
(43) Date of publication of application: **27.05.2026**
(21) Application number: 25218406.4
(22) Date of filing: 25.11.2025
(51) Int. Cl.: H10W 70/40, H10W 90/00

(54) **SEMICONDUCTOR DEVICE AND PACKAGE WITH KELVIN SOURCE CONNECTION**

(30) Priority: 25.11.2024 NL 2039157
(71) Applicant: Nexperia B.V., 6534 AB Nijmegen (NL)
(72) Inventor: Gong, Wei, Manchester (GB); Cao, Pulong, Shanghai (CN); Liu, Hui, Shanghai (CN)
(74) Representative: Pjanovic, Ilija

(57) **Abstract**

A semiconductor device and a semiconductor package including such semiconductor device are presented. The semiconductor device includes one or more dies, a power source clip, a signal source clip, a signal gate clip and a power drain clip, with each clip electrically connected to each of the dies. A Kelvin source connection is integrated on the signal source clip. At at least one of the dies an angle between a path of a power source current between the power source clip and a die and a path of a signal source current between the signal source clip and the die is equal to or larger than 90°.

## Description

### Technical field

The present disclosure relates to semiconductor devices and semiconductor packages including such semiconductor devices, in particular to power semiconductor devices including a Kelvin source connection.

### Background

Wide bandgap (WBG) semiconductor materials, such as silicon carbide (SiC) and gallium nitride (GaN), have become increasingly important in modern power electronics due to their superior performance characteristics compared to traditional silicon-based semiconductors. WBG chips operate at higher voltages, frequencies, and temperatures, making them ideal for applications requiring high efficiency, compact size, and reduced cooling requirements. These properties are particularly crucial in industries such as electric vehicles, renewable energy, and industrial automation, where efficiency and power density are essential for innovation and performance.

In many high-power applications, multiple WBG semiconductor dies are often connected in parallel to meet the required current levels. This parallel configuration enhances power handling capabilities and improves thermal management. However, it also presents the challenge of ensuring uniform current distribution among the parallel chips, which is vital for reliable operation and preventing hotspots that could lead to premature device failure.

In power electronic designs, the method of connecting the source terminals of power semiconductor chips, including, e.g., insulated-gate bipolar transistor (IGBT), SiC metal-oxide-semiconductor field-effect transistor (MOSFET) and GaN based power semiconductor chips, is critical to the overall performance of the system. Two common approaches are the common source connection and the Kelvin source connection.

The common source connection offers the advantage of simplicity, as all parallel SiC or GaN chips share the same source terminal, which simplifies the overall circuit design and reduces wiring complexity. This approach also leads to lower costs due to fewer required pins and simpler wiring. However, common source connections suffer from significant drawbacks, particularly in high-frequency and high-power applications. The shared source terminal introduces parasitic inductance, which can cause uneven current distribution during switching, leading to oscillations, increased noise, and reduced system efficiency. Additionally, the presence of parasitic inductance slows down the switching speed, resulting in higher switching losses and compromised performance.

In contrast, Kelvin source connections provide several advantages that address the limitations of common source designs. By using a separate Kelvin pin for the gate drive, the impact of parasitic inductance is minimized, resulting in a more accurate and stable gate-to-source voltage. This configuration also allows for faster switching speeds, which reduces switching losses and enhances system efficiency. Moreover, the independent gate drive loop for each WBG chip in a Kelvin connection ensures more uniform current distribution, reducing stress on individual chips and improving thermal management. However, Kelvin source connections are not without their disadvantages. They require additional pins and more complex wiring, which can increase design complexity and PCB layout difficulty, e.g., increases the difficulty of substrate - direct bonded copper (DBC) or active metal brazed (AMB) - layout. This, in turn, leads to higher manufacturing costs compared to common source designs.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure aims to overcome the drawbacks identified in the background section.

According to an aspect of the present disclosure, a semiconductor device is presented. The semiconductor device may include one or more dies. The semiconductor device may further include a power source clip that is electrically connected to each of the dies. The semiconductor device may further include a signal source clip that is electrically connected to each of the dies. The semiconductor device may further include a signal gate clip that is electrically connected to each of the dies. The semiconductor device may further include a power drain clip that is electrically connected to each of the dies. A Kelvin source connection may be integrated on the signal source clip. At at least one of the dies, an angle between a path of a power source current, the path of the power source current being located between the power source clip and the at least one of the dies, and a path of a signal source current, the path of the signal source current being located between the signal source clip and the at least one of the dies, is equal to or larger than 90°.

In an embodiment, the semiconductor device may include a plurality of dies connected in parallel with each of the power source clip, the signal source clip, the signal gate clip and the power drain clip.

In an embodiment, the power source clip and the power drain clip may be arranged on opposite sides of the semiconductor device. The power source clip and the signal source clip may be arranged at a same side of the semiconductor device. The power source clip and the signal source clip may be arranged on opposite sides of the at least one of the dies.

In an embodiment, the power source clip and the power drain clip may be arranged at a same side of the semiconductor device. The power source clip and the signal source clip may be arranged at opposite sides of the semiconductor device. The power source clip and the signal source clip may be arranged on opposite sides of the at least one of the dies.

In am embodiment, the semiconductor device may include an overlap without electrical connection in a z-direction between the path of the signal source current and the path of the signal gate current.

In an embodiment, the semiconductor device may be a power semiconductor device.

In an embodiment, the power semiconductor device may be a power switch.

In an embodiment, the power switch may be an insulated-gate bipolar transistor (IGBT).

In an embodiment, the power switch may be a silicon carbide metal-oxide-semiconductor field-effect transistor (SiC) MOSFET.

In an embodiment, the power switch may be a gallium nitride (GaN) based power chip.

According to an aspect of the present disclosure, a semiconductor package is presented. The semiconductor package may include a semiconductor device having one or more of the above-described features

In an embodiment, a power source clip, a signal source clip, a signal gate clip and a power drain clip may extend from the semiconductor package.

In an embodiment, the semiconductor package may include a plurality of semiconductor devices, each semiconductor device having one or more of the above described features.

In an embodiment, the semiconductor device may include two or more power switches.

In an embodiment, the power switch may be a half-bridge power switch.

In an embodiment, the power switch may be an H-bridge power switch.

In an embodiment, the power switch may be a 3-phase power switch.

### Brief description of the Drawings

Embodiments of the present disclosure will now be described, by way of example only, with reference to the accompanying schematic drawings in which corresponding reference symbol indicate corresponding parts, in which:
Fig. 1A and Fig. 1B are top views of an example prior art power semiconductor device;
Fig. 2A and Fig. 2B are top views of an example embodiment of an improved power semiconductor device of the present disclosure;
Fig. 3A, Fig. 3B and Fig. 3C are a 3D view, a top view and a side view, respectively, of an example embodiment of a semiconductor package;
Fig. 4A and Fig. 4B are top views of another example embodiment of the internals an improved power semiconductor device of the present disclosure;
Fig. 5 is a top view of and example embodiment of a semiconductor package; and
Fig. 6 and Fig. 7 are side views of improved power semiconductor devices of example embodiments of the present disclosure.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

The present disclosure offers a novel approach that combines the benefits of Kelvin source connections with the simplicity of common source designs. By integrating the Kelvin source directly into the source clip of the power package, the solution of the present disclosure effectively addresses and overcomes the limitations of both traditional designs. The configuration of the present disclosure minimizes parasitic inductance, ensuring faster switching speeds and more uniform current distribution among the parallel WBG semiconductor dies. As a result, the solution of the present disclosure significantly reduces switching losses and improves overall system efficiency and reliability. Furthermore, the design eliminates the need for extra space on the substrate for the Kelvin source trace, simplifying the layout and reducing the manufacturing complexity and costs typically associated with Kelvin source connections. The outcome is a more compact, cost-effective, and high-performance power package that is well-suited for demanding applications requiring the advanced capabilities of, e.g., SiC and GaN technologies.

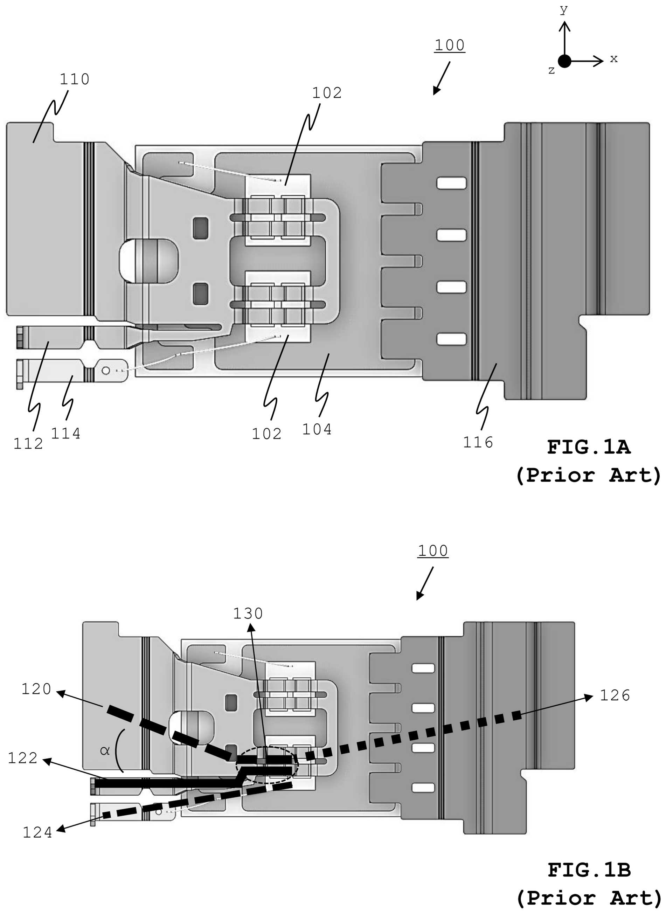

Fig. 1A shows the internals of a prior art common source solution of a power semiconductor device 100, e.g., a power switch. Power semiconductor device 100 may be packaged as a thin package, also known as ThinPAK or TPAK. In the example of Fig. 1A, two semiconductor dies 102 are connected in parallel onto a substrate 104. A power source clip 110, a signal source clip 112, a signal gate clip 114 and a power drain clip 116 are connected to each of the dies 102.

Fig. 1B shows the same power semiconductor device 100, indicating current flows through the clips to and from each of the dies 102. A power source current 120 flows between the power source clip 110 and a die 102, a signal source current 122 (also known as control source current) flows between the signal source clip 112 and the die 102, a signal gate current 124 flows between the signal gate clip 114 and the die 102, and a power drain current 126 flows between the power drain clip 116 and the die 102.

Notably, there is an overlap 130 between the power source current 120 and the signal source current 122. The angle α shown in Fig. 1B depicts the angle between the path of the power source current 120 and the path of the signal source current 122 at the die 102. In the example of Fig. 1B, and as a result of the overlap 130, the angle α is about 0°. Other prior art common source solutions of power semiconductor devices have in common that there is an overlap between the power source current and the signal source current and that angle α is smaller than 90° and typically about 0°. The drawbacks of common source connections identified in the background section apply to the power semiconductor device 100.

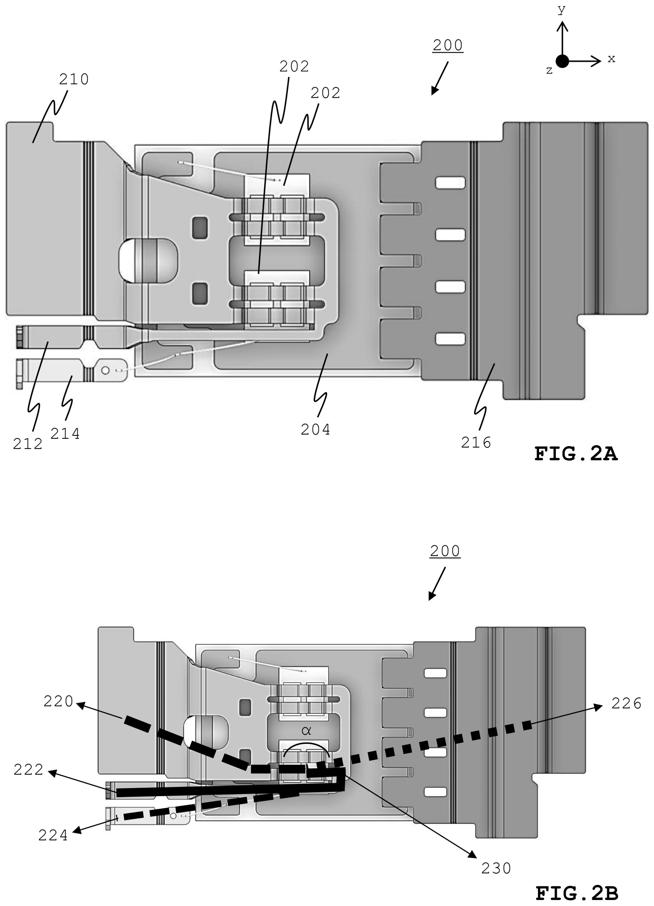

Fig. 2A shows an example embodiment of an improved Kelvin source solution of a power semiconductor device 200 of the present disclosure. Power semiconductor device 200 may be packaged as a TPAK. In the example of Fig. 2A, two semiconductor dies 202 are connected in parallel onto a substrate 204, but there may be any other number of dies, including just one die. A power source clip 210, a signal source clip 212, a signal gate clip 214 and a power drain clip 216 are connected to each of the dies 202.

Fig. 2B shows the same power semiconductor device 200, indicating current flows through the clips to and from each of the dies 202. A power source current 220 flows between the power source clip 210 and a die 202, a signal source current 222 (also known as control source current) flows between the signal source clip 212 and the die 202, a signal gate current 224 flows between the signal gate clip 214 and the die 202, and a power drain current 226 flows between the power drain clip 216 and the die 202.

The power source clip 210 may be connect to one side of a die 202 and the signal source clip 212 may be connected to another side of the die 202. As a result, there is no overlap (depicted 230) between the power source current 220 and the signal source current 222. The angle α shown in Fig. 2B depicts the angle between the path of the power source current 220 and the path of the signal source current 222 at the die 202. In the example of Fig. 2B, and as a result of there not being an overlap (depicted 230), the angle α is about 180°. Other Kelvin source solutions of power semiconductor devices of the present disclosure such as power semiconductor device 200 have in common that angle α is larger than or equal to 90°, resulting in there not being an overlap between the power source current and the signal source current. The above-described advantages of the solution of the present disclosure apply to the power semiconductor device 200.

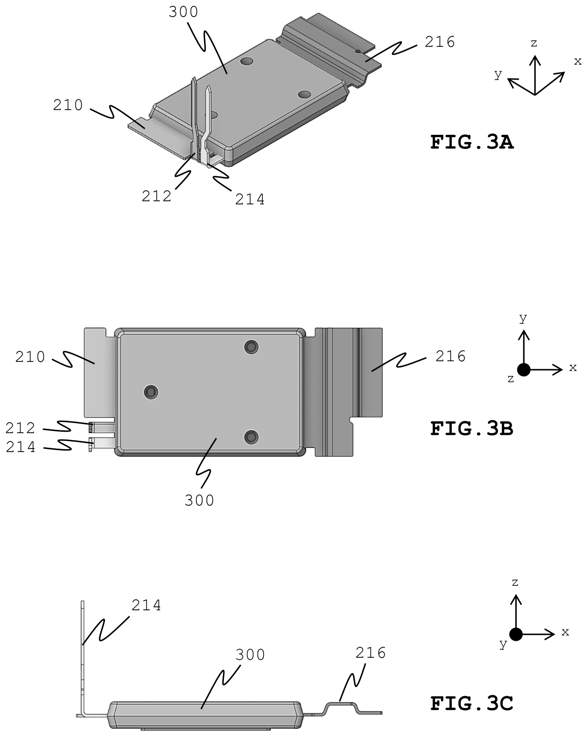

Fig. 3A, Fig. 3B and Fig. 3C show an example embodiment of a semiconductor package 300, in this example a TPAK package, including a power semiconductor device according to the present disclosure, such as power semiconductor device 200. Shown are the power source clip 210, the signal source clip 212, the signal gate clip 214 and the power drain clip 216 extending from the semiconductor package 300. The semiconductor package may include a baseplate, a ceramic layer, power terminals and control terminals.

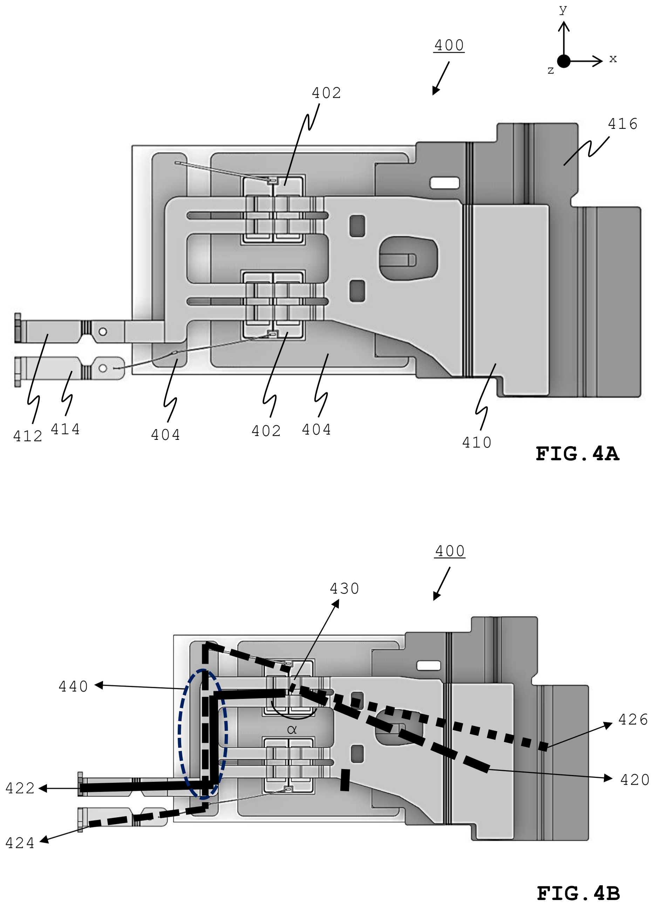

Fig. 4A shows another example embodiment of an improved Kelvin source solution of a power semiconductor device 400 of the present disclosure. Different from the power semiconductor device 200 of Fig. 2A, the power semiconductor device 400 has its power source clip 410 at the same side as the power drain clip 416. Power semiconductor device 400 may be packaged as a TPAK. In the example of Fig. 4A, two semiconductor dies 402 are connected in parallel onto a substrate 404, but there may be any other number of dies, including just one die. The power source clip 410, a signal source clip 412, a signal gate clip 414 and the power drain clip 416 are connected to each of the dies 402.

Fig. 4B shows the same power semiconductor device 400, indicating current flows through the clips to and from each of the dies 402. A power source current 420 flows between the power source clip 410 and a die 402, a signal source current 422 (also known as control source current) flows between the signal source clip 412 and the die 402, a signal gate current 424 flows between the signal gate clip 414 and the die 402, and a power drain current 426 flows between the power drain clip 416 and the die 402.

The power source clip 410 may be connect to one side of a die 402 and the signal source clip 412 may be connected to another side of the die 402. As a result, there is no overlap 430 between the power source current 420 and the signal source current 422. The angle α shown in Fig. 4B depicts the angle between the path of the power source current 420 and the path of the signal source current 422 at the die 402. In the example of Fig. 4B, and as a result of there not being an overlap 430, the angle α is about 160°. Other Kelvin source solutions of power semiconductor devices of the present disclosure such as power semiconductor device 400 have in common that angle α is larger than or equal to 90°, resulting in there not being an overlap between the power source current and the signal source current. The above-described advantages of the solution of the present disclosure apply to the power semiconductor device 400.

In the power semiconductor device 400, there may be an overlap 440 in the z-direction between the Kelvin source on the clip (i.e., in the path of the signal source current 422) and the gate trace on the substrate 404 (i.e., in the path of the signal gate current 424). Note that there is no electrical connection between the Kelvin source on the clip and the gate trace on the substrate at the overlap 440. Advantageously, the overlap 440 reduces the control loop parasitic inductance.

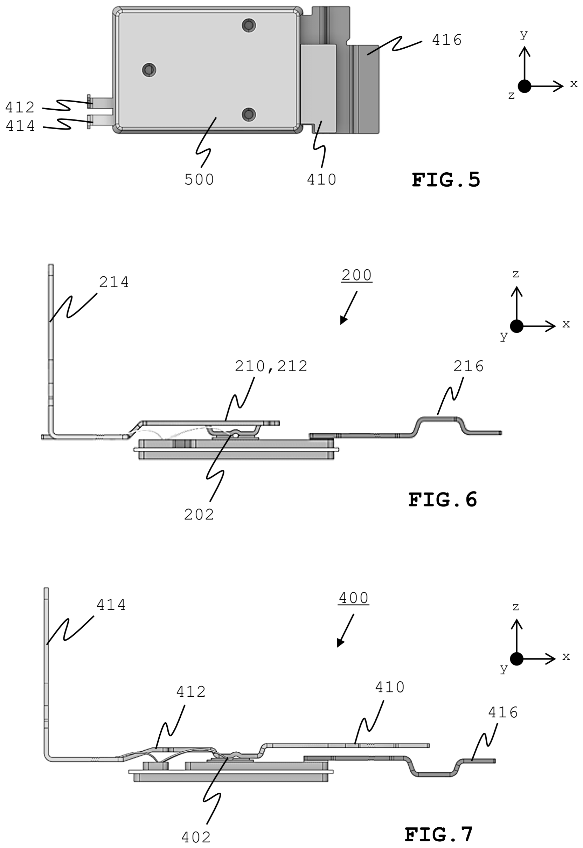

Fig. 5 show an example embodiment of a semiconductor package 500, in this example a TPAK package, including a power semiconductor device according to the present disclosure, such as power semiconductor device 400. Shown are the power source clip 410, the signal source clip 412, the signal gate clip 414 and the power drain clip 416 extending from the semiconductor package 500.

Fig. 6 and Fig. 7 are side views of the power semiconductor devices 200 and 400, respectively. Fig. 7 shows the power source clip 210 being oriented towards the other side as the power drain clip 216. Fig. 7 shows the power source clip 410 being oriented towards the same side as the power drain clip 416.

Non-limiting examples of power semiconductor dies 202, 402 are IGBT, SiC MOSFET and GaN.

The semiconductor power package of the present disclosure may be a discrete package with one switch, a power module with two switches, or other kind of circuit topology. In an embodiment, two or more power semiconductor dies may be parallel connected in at least one of the power switches.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A semiconductor device (200, 400) comprising:
one or more dies (202, 402);
a power source clip (210, 410) electrically connected to each of the dies (202, 402);
a signal source clip (212, 412) electrically connected to each of the dies (202, 402);
a signal gate clip (214, 414) electrically connected to each of the dies (202, 402); and
a power drain clip (216, 416) electrically connected to each of the dies (202, 402),
wherein a Kelvin source connection is integrated on the signal source clip (212, 412),
and wherein, at at least one of the dies (202, 402) an angle (α) between a path of a power source current (220, 420) between the power source clip (210, 410) and the at least one of the dies (202, 402) and a path of a signal source current (222, 422) between the signal source clip (212, 412) and the at least one of the dies (202, 402) is equal to or larger than 90°.

2. The semiconductor device (200, 400) according to claim 1, comprising a plurality of dies (202, 402) connected in parallel with each of the power source clip, the signal source clip, the signal gate clip and the power drain clip.

3. The semiconductor device (200) according to claim 1 or claim 2,
wherein the power source clip (210) and the power drain clip (216) are arranged on opposite sides of the semiconductor device (200),
wherein the power source clip (210) and the signal source clip (212) are arranged at a same side of the semiconductor device (200),
and wherein the power source clip (210) and the signal source clip (212) are arranged on opposite sides of the at least one of the dies (202).

4. The semiconductor device (400) according to claim 1 or claim 2,
wherein the power source clip (410) and the power drain clip (416) are arranged at a same side of the semiconductor device (400),
wherein the power source clip (410) and the signal source clip (412) are arranged at opposite sides of the semiconductor device (400),
and wherein the power source clip (410) and the signal source clip (212) are arranged on opposite sides of the at least one of the dies (402).

5. The semiconductor device (400) according to claim 4, comprising an overlap (440) without electrical connection in a z-direction between the path of the signal source current (422) and the path of the signal gate current (424).

6. The semiconductor device (200, 400) according to any one of the preceding claims, wherein semiconductor device is a power semiconductor device, preferably a power switch such as an insulated-gate bipolar transistor, IGBT, a silicon carbide metal-oxide-semiconductor field-effect transistor, SiC MOSFET, or a gallium nitride based power chip, GaN.

7. A semiconductor package (300, 500) comprising a semiconductor device according to any one of the claims 1-6.

8. The semiconductor package (300, 500) according to claim 7, wherein a power source clip, a signal source clip, a signal gate clip and a power drain clip extend from the semiconductor package.

9. The semiconductor package (300, 500) according to claim 7 or claim 8, comprising a plurality of semiconductor devices according to any one of the claims 1-6.

10. The semiconductor package (300, 500) according to any one of the claims 7-9, wherein the semiconductor device comprises two or more power switches.

11. The semiconductor package (300, 500) according to claim 10, wherein the power switch is a half-bridge power switch, an H-bridge power switch or a 3-phase power switch.
